(19) Europäisches Patentamt
European Patent Office
Office européen des brevets

(11) **EP 2 770 591 A2**

(12) **EUROPEAN PATENT APPLICATION**

(43) Date of publication:
**27.08.2014 Bulletin 2014/35**

(51) Int Cl.:
***H01S 5/10*** *(2006.01)*   *H01S 5/22* *(2006.01)*
***H01S 5/343*** *(2006.01)*

(21) Application number: **14000289.0**

(22) Date of filing: **28.01.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **25.02.2013 JP 2013034820**

(71) Applicant: **Sony Corporation Tokyo 108-0075 (JP)**

(72) Inventor: **Abe, Hiroaki Tokyo 108-0075 (JP)**

(74) Representative: **Müller - Hoffmann & Partner Patentanwälte St.-Martin-Strasse 58 81541 München (DE)**

(54) **Semiconductor light-emitting element, method for producing the same, and display apparatus**

(57)   A semiconductor light-emitting element includes a substrate (10, a recess (20) in the substrate (10), and a ridge portion (30) disposed in the recess (20), the ridge portion (30) having a constant width, in which the recess (20) has a width that varies in the longitudinal direction of the ridge portion (30), the ridge portion (30) is formed of a compound semiconductor multilayer structure including an active layer (43), and the active layer (43) has a thickness that varies in the longitudinal direction of the ridge portion (30).

FIG. 1A

EP 2 770 591 A2

**Description**

CROSS REFERENCE TO RELATED APPLICATIONS

This application claims the benefit of Japanese Priority Patent Application JP 2013-034820 filed February 25, 2013.

BACKGROUND

The present disclosure relates to a semiconductor light-emitting element, a method for producing the semiconductor light-emitting element, and a display apparatus including the semiconductor light-emitting element.

For example, Japanese Unexamined Patent Application Publication No. 2009-025462 discloses a display apparatus, such as a projection apparatus equipped with a semiconductor light-emitting element formed of a semiconductor laser element as a light source, i.e., a laser display apparatus. Laser display apparatuses have the advantages of high brightness, high definition, smallness, lightness, and low power consumption and thus have been attracting much attention. In laser display apparatuses, however, speckle noise causes the degradation of the quality of images and video images. Speckle noise is a phenomenon resulting from the interference of scattering light on a laser irradiation plane, e.g., a screen or a wall surface, where an image or a video image is displayed because of high coherence of laser light, and is attributed to minute irregularities on the laser irradiation plane. Meanwhile, speckle contrast C is expressed by the following formula (1),

$$ C \ = \ [1/\{2\,(2\cdot\pi\cdot\sigma_h\cdot\Delta\lambda/\lambda^2)^2 \ + \ 1\}]^{1/4} \qquad (1) $$

where $\lambda$ represents the wavelength of laser light, $\sigma_h$ represents the surface roughness of the laser irradiation plane, and $\Delta\lambda$ represents the width of the oscillation wavelength of the laser light. The formula (1) demonstrates that an increase in the width $\Delta\lambda$ of the oscillation wavelength of the laser light results in a reduction in the level of speckle noise.

SUMMARY

Japanese Unexamined Patent Application Publication No. 06-275904 discloses a semiconductor laser including a groove and a ridge in a semiconductor substrate, the groove having a portion with a narrow width and a portion with a wide width, and the ridge being disposed throughout the recess. The astigmatism of a laser beam is maintained at a low level by reducing the width of a portion of the groove located at a laser light-emitting surface and increasing the width of a portion of the groove opposite the laser light-emitting surface. Furthermore, in the semiconductor laser, longitudinal-mode oscillation as a whole is multimode oscillation. In the technique disclosed in the patent document, however, the ridge is disposed throughout the groove. Thus, when an active layer or the like is formed, a portion of the active layer or the like in the vicinity of an edge portion of the groove is liable to be formed into a polycrystalline portion to degrade the crystallinity of the active layer or the like. It is thus difficult to produce a highly reliable semiconductor laser.

Japanese Unexamined Patent Application Publication No. 07-135372 discloses a semiconductor optical amplifier produced by forming a mask on a substrate, the mask being composed of a dielectric material and so forth and having different widths, and selectively growing an active layer and so forth on an exposed portion of the substrate, in which the active layer has a first band gap wavelength in the vicinity of a light-receiving end and a second band gap wavelength in the vicinity of a light-emitting end, the second band gap wavelength being shorter than the first band gap wavelength. In the technique disclosed in this patent document, the band gap wavelength of the active layer is controlled by the fact that the indium (In) content of the active layer is increased in a wide portion of the mask. However, the active layer or the like in the vicinity of an edge portion of the mask is liable to be formed into a polycrystalline portion to degrade the crystallinity of the active layer or the like, reducing the reliability. Furthermore, a stripe-shaped optical waveguide is formed between masks, thus disadvantageously increasing the optical confinement to cause a higher-order mode.

It is desirable to provide a highly reliable semiconductor light-emitting element in which a reduction in the crystallinity of an active layer is suppressed, a method for producing the semiconductor light-emitting element, and a display apparatus including the semiconductor light-emitting element.

Various respective aspects and features of the invention are defined in the appended claims.

A semiconductor light-emitting element according to an embodiment of the present disclosure includes a ridge portion disposed in a recess in a substrate, the ridge portion having a constant width, in which the recess has a width that varies in the longitudinal direction of the ridge portion, the ridge portion is formed of a compound semiconductor multilayer structure including an active layer, and the active layer has a thickness that varies in the longitudinal direction of the ridge portion.

A method for producing a semiconductor light-emitting element according to an embodiment of the present disclosure includes forming a recess in a substrate, the recess having a width that varies in the longitudinal direction of a ridge portion to be formed; and forming a compound semiconductor multilayer structure including an active layer on the substrate, the active layer having a thickness that varies in the longitudinal direction of the ridge portion to be formed, and then forming the ridge portion by etching a portion of the compound semiconductor multilayer structure in the recess, the ridge portion having a constant width.

A display apparatus according to an embodiment of the present disclosure includes the foregoing semiconductor light-emitting element according to an embodiment of the present disclosure.

In the present disclosure, the at least has a thickness that varies in the longitudinal direction of the ridge portion. In other words, the gain is not uniform in a resonator, thereby increasing the value of the wavelength width $\Delta\lambda$ of light emitted from the semiconductor light-emitting element. This results in a reduction in the level of speckle noise owing to the semiconductor light-emitting element itself on the basis of the foregoing formula (1) without using a complex elemental structure or a complex circuit. Furthermore, the ridge portion having a constant width is disposed in the recess in the substrate, in other words, the width of the ridge portion is narrower than the width of the recess. It is thus possible to provide the highly reliable semiconductor light-emitting element without reducing the crystallinity of the compound semiconductor multilayer structure including the active layer.

BRIEF DESCRIPTION OF THE DRAWINGS

Fig. 1A is a schematic plan view of a semiconductor light-emitting element according to a first embodiment, Fig. 1B is a schematic cross-sectional view of the semiconductor light-emitting element according to the first embodiment, the cross-sectional view being taken along line IB-IB of Fig. 1A, and Fig. 1C is a schematic cross-sectional view of the semiconductor light-emitting element according to the first embodiment, the cross-sectional view being taken along line IC-IC of Fig. 1A;

Fig. 2A is a schematic partial plan view of a recess in a substrate, and Fig. 2B is a schematic partial cross-sectional view of the substrate, the cross-sectional view being taken along line IIB-IIB of Fig. 2A;

Figs. 3A and 3B are schematic partial cross-sectional views of a substrate and so forth for the purpose of explaining a method for producing the semiconductor light-emitting element of the first embodiment, and Fig. 3C is a partially enlarged schematic cross-sectional view of the semiconductor light-emitting element according to the first embodiment, the cross-sectional view being taken along line IIIC-IIIC of Fig. 1A;

Fig. 4 is a graph illustrating the measurement results of the gain peak wavelength of semiconductor emission by a photoluminescence (PL) method on the basis of a compound semiconductor multilayer structure of the first embodiment;

Figs. 5A and 5B are scanning electron micrographs of a compound semiconductor multilayer structure and so forth produced in [Step-110] in a method for producing a semiconductor light-emitting element according to the first embodiment;

Figs. 6A and 6B are scanning electron micrographs of a compound semiconductor multilayer structure and so forth produced in [Step-120] in the method for producing a semiconductor light-emitting element according to the first embodiment;

Figs. 7A and 7B illustrate gain curves of semiconductor light-emitting elements according to the first embodiment and a first comparative embodiment;

Figs. 8A and 8B illustrate emission spectra of the semiconductor light-emitting elements according to the first embodiment and the first comparative embodiment;

Fig. 9 is a conceptual diagram of a display apparatus according to a second embodiment;

Fig. 10 is a conceptual diagram of another display apparatus according to the second embodiment;

Figs. 11A and 11B are schematic partial plan views of recesses in substrates according to modified embodiments; and

Fig. 12 is a schematic partial plan view of a recess in a substrate according to another modified embodiment.

DETAILED DESCRIPTION OF EMBODIMENTS

The present disclosure will be described below on the basis of embodiments with reference to the attached drawings. However, the present disclosure is not limited to the embodiments. Various values and materials described in the embodiments are merely for illustration purposes. Note that the present disclosure will be described in the following order:

1. a semiconductor light-emitting element of an embodiment of the present disclosure, a method for producing the semiconductor light-emitting element, a display apparatus, and a general explanation;

2. a first embodiment (a semiconductor light-emitting element of the first embodiment of the present disclosure and a method for producing the semiconductor light-emitting element); and

3. a second embodiment (a display apparatus according to a second embodiment of the present disclosure) and other things. [Semiconductor light-emitting element of embodiment of the present disclosure, method for producing semiconductor light-emitting element, display apparatus, and general explanation]

In the semiconductor light-emitting element of an embodiment of the present disclosure or the semiconductor light-emitting element included in a display apparatus according to an embodiment of the present disclosure (hereinafter, also referred to collectively as a "semiconductor light-emitting element and so forth according to an embodiment of the present disclosure"), the composition of an active layer may vary in the longitudinal direction of a ridge portion. The method for producing a semiconductor light-emitting element according to an embodiment of the present disclosure may include forming an active layer with a thickness and a composition that vary in the longitudinal direction of a ridge portion to be formed.

In the semiconductor light-emitting element and so forth according to the foregoing preferred embodiment of the present disclosure, a side structure formed of a compound semiconductor multilayer structure is preferably disposed on each side of the ridge portion in a recess with a distance kept between each side structure and the ridge portion. The method for producing a semiconductor light-emitting element according to the foregoing preferred embodiment of the present disclosure preferably includes simultaneously forming side structures and the ridge portion with a distance kept between each of the side structures and the ridge portion, each of the side structures being formed of a compound semiconductor multilayer structure and being disposed on each side of the ridge portion in a recess.

In the semiconductor light-emitting element and so forth according to the foregoing preferred embodiment of the present disclosure or in the method for producing a semiconductor light-emitting element according to the foregoing preferred embodiment of the present disclosure, in order to surely vary the thickness of the active layer in the longitudinal direction of the ridge portion, surely form the ridge portion having a constant width in the recess, and produce a high-quality compound semiconductor multilayer structure, the recess preferably has a depth of 0.5 $\mu$m or more and 10 $\mu$m or less. An example of the lower limit of the width of the recess is 6 $\mu$m.

In the semiconductor light-emitting element and so forth according to the foregoing preferred embodiment of the present disclosure or in the method for producing a semiconductor light-emitting element according to the foregoing preferred embodiment of the present disclosure, the following expression is preferably satisfied:

$$0.8 \leq (W_{max} - W_{min})/W_{ave} \leq 2$$

where $W_{max}$ represents the maximum width of the recess, $W_{min}$ represents the minimum width of the recess, and Wave represents the average width of the recess. Table 1 illustrates exemplary values of $W_{max}$, $W_{min}$, and Wave in a semiconductor light-emitting element configured to emit red light.

Table 1

| | $W_{max}$ ($\mu$m) | $W_{min}$ ($\mu$m) | $W_{ave}$ ($\mu$m) |
|---|---|---|---|
| Semiconductor light-emitting element configured to emit red light | 14 to 300 | 6 to 150 | 10 to 147 |

In the semiconductor light-emitting element and so forth according to the foregoing preferred embodiment of the present disclosure or in the method for producing a semiconductor light-emitting element according to the foregoing preferred embodiment of the present disclosure, a larger value of $\Delta\lambda/\lambda_{max}$ is more preferred from the viewpoint of reducing speckle noise, where $\lambda_{max}$ represents the peak maximum of wavelengths of light emitted from the semiconductor light-emitting element, and $\Delta\lambda$, represents the wavelength width of the light. An example of the lower limit of the value of $\Delta\lambda/\lambda_{max}$ is, but not limited to, $1.5 \times 10^{-4}$. In the case where the semiconductor light-emitting element is formed of a semiconductor laser element, the peak maximum $\lambda_{max}$ of wavelengths of light emitted from the semiconductor light-emitting element and the wavelength width $\Delta\lambda$ of light refer to the peak maximum of an oscillation wavelength and the width of the oscillation wavelength, respectively. In the case where the semiconductor light-emitting element is composed of a superluminescent diode, the peak maximum $\lambda_{max}$ of wavelengths of light emitted from the semiconductor light-emitting element and the wavelength width $\Delta\lambda$ of light refer to the peak maximum of an emission wavelength and the width of the emission wavelength.

In the semiconductor light-emitting element and so forth according to the foregoing preferred embodiment of the present disclosure or in the method for producing a semiconductor light-emitting element according to the foregoing preferred embodiment of the present disclosure, the following expression is preferably satisfied:

$$0.01 \leq (T_{max} - T_{min})/T_{ave} \leq 0.1$$

where $T_{max}$ represents the maximum thickness of the active layer, $T_{min}$ represents the minimum thickness of the active layer, and $T_{ave}$ represents the average thickness of the active layer. In this case, a portion of the active layer in the vicinity of a light-emitting surface preferably has a minimum thickness.

In the semiconductor light-emitting element and so forth according to the foregoing preferred embodiment of the present disclosure or in the method for producing a semiconductor light-emitting element according to the foregoing preferred embodiment of the present disclosure, the active layer may be composed of an AlGaInP-based compound semiconductor. In this case, the active layer may have a quantum well structure in which a well layer including a GaInP layer or an AlGaInP layer and a barrier layer including an AlGaInP layer are stacked. A portion of the active layer in the vicinity of the light-emitting surface may have a minimum In content. Alternatively, the active layer may be composed of a GaInN-based compound semiconductor. In this case, the active layer may have a quantum well structure in which a well layer including a GaInN layer and a barrier layer including a GaInN layer having an In content different from the In content of the well layer are stacked. A portion of the active layer in the vicinity of the light-emitting surface may have a minimum In content. While the structure of the compound semiconductor multilayer structure may be a structure in the related art, the compound semiconductor multilayer structure is provided on a substrate and has a structure in which a first compound semiconductor layer, the active layer, and a second compound semiconductor layer are stacked, in that order, from the substrate. The first compound semiconductor layer or the substrate is connected to a first electrode. The second compound semiconductor layer is connected to a second electrode.

In the semiconductor light-emitting element and so forth according to the foregoing preferred embodiment of the present disclosure or in the method for producing a semiconductor light-emitting element according to the foregoing preferred embodiment of the present disclosure, the semiconductor light-emitting element may be formed of a semiconductor laser element or a superluminescent diode (SLD). In the case of the semiconductor laser element, a resonator is provided by the optimization of the reflectivity of the light-emitting surface and the reflectivity of a light-reflecting surface. In the case of the superluminescent diode, the reflectivity of the light-emitting surface is set to a very low level, and the reflectivity of the light-reflecting surface is set to a very high level. Thereby, light generated in the active layer is reflected from the light-reflecting surface and emerges from the light-emitting surface without forming a resonator. Commonly, an antireflective coating (AR) or a low-reflection coating is formed on a light-emitting surface. A high-reflection coating (HR) is formed on the light-reflecting surface. An example of the antireflective coating (low-reflection coating) is a multilayer structure including at least two layers selected from a titanium oxide layer, a tantalum oxide layer, a zirconium oxide layer, a silicon oxide layer, aluminum oxide layer, aluminum nitride layer, and a silicon nitride layer.

In the semiconductor light-emitting element and so forth according to the foregoing preferred embodiment of the present disclosure, a high-frequency signal (for example, 100 MHz to 300 MHz) is superimposed on a driving current in driving the element to cause gain fluctuation, thereby further increasing the value of $\Delta\lambda/\lambda_{max}$ to more effectively reduce the speckle noise.

Examples of the display apparatus according to an embodiment of the present disclosure include projection apparatuses, image display apparatuses, monitoring apparatuses, reflective liquid crystal displays, head-mounted displays (HMDs), head-up displays (HUDs), and laser illumination, which are equipped with semiconductor light-emitting elements as light sources. Furthermore, the semiconductor light-emitting element according to an embodiment of the present disclosure may be used as a light source for a laser microscope.

An example of the width of the ridge portion is 1.0 $\mu$m to 3.0 $\mu$m. An excessively large width of the ridge portion may cause a higher-order transverse mode. Thus, the ridge portion may have a width in such a manner that the higher-order transverse mode does not occur.

Examples of the substrate include a GaAs substrate, a GaP substrate, an AlN substrate, an AlP substrate, an InN substrate, an InP substrate, an AlGaInN substrate, an AlGaN substrate, an AlInN substrate, an AlGaInP substrate, an AlGaP substrate, an AlInP substrate, a GaInP substrate, a ZnS substrate, a sapphire substrate, a SiC substrate, an alumina substrate, a ZnO substrate, a LiMgO substrate, a LiGaO$_2$ substrate, a MgAl$_2$O$_4$ substrate, a Si substrate, and a Ge substrate. Furthermore, a component in which a buffer layer and an intermediate layer are disposed on a surface (main surface) of any of these substrates may be used as a substrate. Regarding main surfaces of these substrates, depending on their crystal structures, such as cubic systems and hexagonal systems, crystal planes, such as what is called A-plane, B-plane, C-plane, R-plane, M-plane, N-plane, S-plane, and so forth, may be used. Alternatively, for example, planes in which these planes are inclined in specific directions may be used.

Examples of an n-type impurity added to the compound semiconductor layers included in the compound semiconductor multilayer structure include silicon (Si), germanium (Ge), selenium (Se), tin (Sn), carbon (C), tellurium (Te), sulfur (S), oxygen (O), and palladium (Pd). Examples of a p-type impurity added to the compound semiconductor layers included in the compound semiconductor multilayer structure include zinc (Zn), magnesium (Mg), beryllium (Be), cadmium (Cd), calcium (Ca), and barium (Ba). The active layer may have a single quantum well structure (QW structure) or a multi-quantum well structure (MQW structure). Examples of a method for producing the compound semiconductor multilayer structure (deposition method) include a metal-organic chemical vapor deposition (MOCVD) method, a metal-organic vapor-phase epitaxy (MOVPE) method, a metal-organic molecular beam epitaxy (MOMBE) method, a hydride vapor-phase epitaxy (HVPE) method in which a halogen contributes to transport or reaction, and a plasma-assisted physical vapor deposition (PPD) method. Examples of a method for forming a recess and a method for etching the compound semiconductor multilayer structure include combinations of lithography technology and wet-etching etching technology; and combinations of lithography technology and dry-etching etching technology.

The compound semiconductor multilayer structure is connected to the first electrode and the second electrode. In the case where the first electrode or the second electrode is formed on the compound semiconductor layer or the substrate having a p-type conductivity, examples of the electrode (p-side electrode) include Au/AuZn, Au/Pt/Ti(/Au)/AuZn, Au/AuPd, Au/Pt/Ti(/Au)/AuPd, Au/Pt/TiW(/Ti)(/Au)/AuPd, Au/Pt/Ti, and Au/Ti. In the case where the first electrode or the second electrode is formed on the compound semiconductor layer or the substrate having an n-type conductivity, examples of the electrode (n-side electrode) include Au/Ni/AuGe, Au/Pt/Ti(/Au)/Ni/AuGe, and Au/Pt/TiW(/Ti)/Ni/AuGe. Here, layers are separated by "/", and a layer located more forward is located at a position electrically further from the active layer. The first electrode is electrically connected to the first compound semiconductor layer. The first electrode may be formed on the first compound semiconductor layer. The first electrode may be connected to the first compound semiconductor layer with a conductive material layer or a conductive substrate provided therebetween. The first electrode and the second electrode may be formed by any of various PVD methods, such as vacuum evaporation methods and sputtering methods. A pad electrode may be provided on the first electrode and the second electrode in order to establish an electrical connection with an external electrode or circuit. The pad electrode preferably has a single-layer structure or multilayer structure containing at least one metal selected from titanium (Ti), aluminum (Al), platinum (Pt), gold (Au), and nickel (Ni). Alternatively, the pad electrode may have a multilayer structure, for example, a Ti/Pt/Au multilayer structure or a Ti/Au multilayer structure.

First embodiment

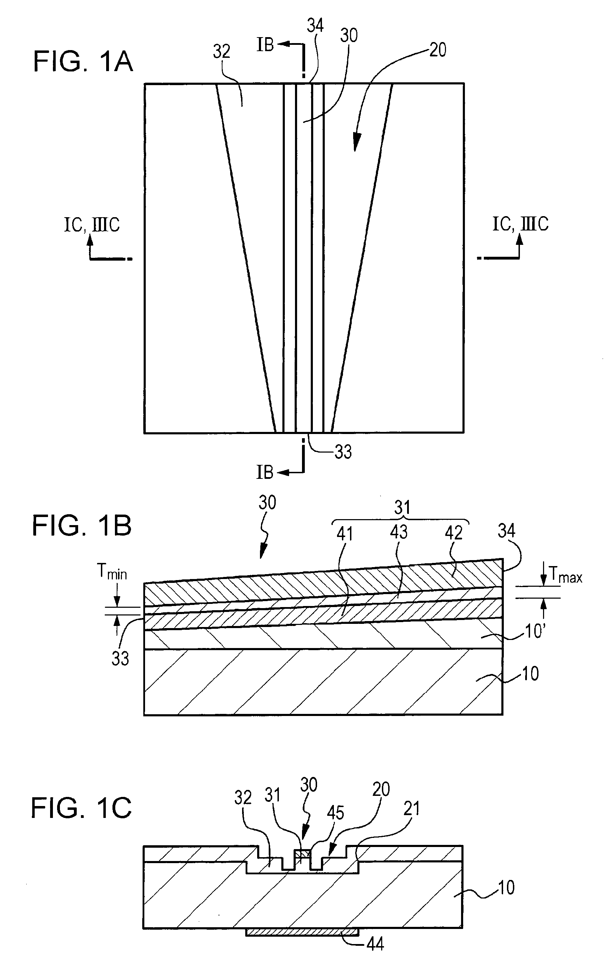

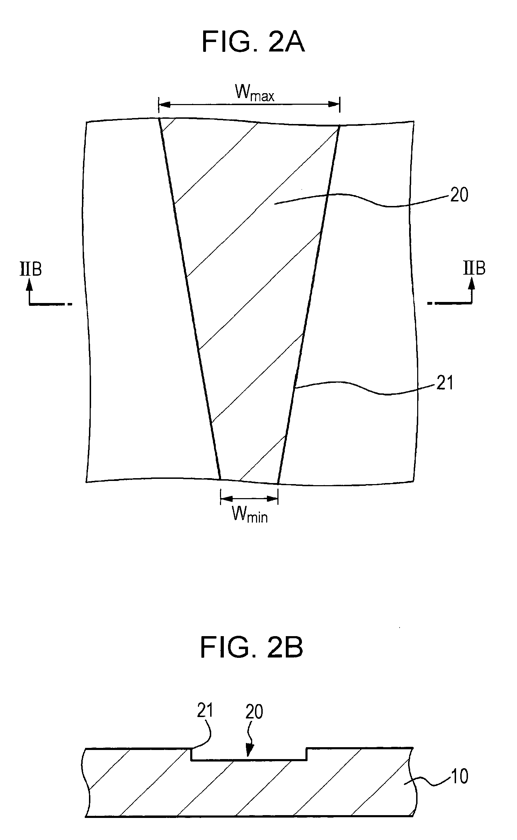

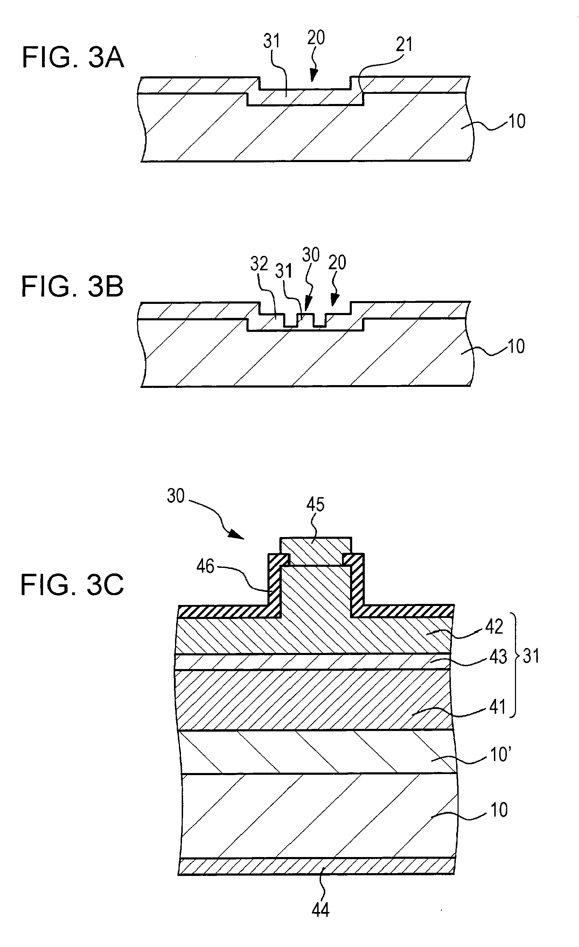

A semiconductor light-emitting element according to a first embodiment of the present disclosure and a method for producing the semiconductor light-emitting element will be described below. Fig. 1A is a schematic plan view of the semiconductor light-emitting element according to the first embodiment. Fig. 1B is a schematic cross-sectional view of the semiconductor light-emitting element according to the first embodiment, the cross-sectional view being taken along line IB-IB of Fig. 1A. Fig. 1C is a schematic cross-sectional view of the semiconductor light-emitting element according to the first embodiment, the cross-sectional view being taken along line IC-IC of Fig. 1A. Fig. 2A is a schematic partial plan view of a recess in a substrate. Fig. 2B is a schematic partial cross-sectional view of the substrate, the cross-sectional view being taken along line IIB-IIB of Fig. 2A. Fig. 3C is a partially enlarged schematic cross-sectional view of the semiconductor light-emitting element according to the first embodiment, the cross-sectional view being taken along line IIIC-IIIC of Fig. 1A. In Fig. 1C and Figs. 3A and 3B described below, the first compound semiconductor layer, the active layer, and the second compound semiconductor layer are illustrated by a single layer (compound semiconductor multilayer structure), and a buffer layer is not illustrated. In Fig. 1B, the first electrode and the second electrode are not illustrated. In Figs. 1B, 1C, and 3C, different scales are used in the thickness direction. In Fig. 2A and Figs. 11A, 11B, and 12 described below, in order to clearly illustrate the recess, the recess is shaded.

The semiconductor light-emitting element (specifically, a semiconductor laser element) according to the first embodiment includes a ridge portion 30 having a constant width. Here, the ridge portion 30 is formed in a recess 20 of a substrate 10. The width of the ridge portion 30 is smaller than that of the recess 20. The width of the recess 20 varies in the longitudinal direction of the ridge portion 30. The ridge portion 30 includes a compound semiconductor multilayer structure 31 including an active layer 43. The thickness of the active layer 43 varies in the longitudinal direction of the ridge portion 30.

In the first embodiment, the length of a resonator (the length of the ridge portion 30) is 1.00 mm. A side structure 32 formed of the compound semiconductor multilayer structure 31 is provided on each side of the ridge portion 30 in the recess 20 with a distance kept between the side structures 32 and the ridge portion 30. The recess 20 has a depth of 0.5 $\mu$m or more and 10 $\mu$m or less. In the first embodiment, specifically, the recess 20 has a depth of 2 $\mu$m. The recess 20 has linear edge portions 21. The recess 20 satisfies the expression:

$$0.8 \le (W_{max} - W_{min})/W_{ave} \le 2$$

where $W_{max}$ represents the maximum width of the recess 20, $W_{min}$ represents the minimum width of the recess 20, and Wave represents the average width of the recess 20. Specifically,

$W_{max}$ = 94 $\mu$m;

$W_{min}$ = 24 $\mu$m; and

$W_{ave}$ = 59 $\mu$m.

The ridge portion 30 has a constant width of 2.0 $\mu$m. The active layer 43 satisfies the expression:

$$0.01 \le (T_{max} - T_{min})/T_{ave} \le 0.1$$

where $T_{max}$ represents the maximum thickness of the active layer 43, $T_{min}$ represents the minimum thickness of the active layer 43, and $T_{ave}$ represents the average thickness of the active layer 43. Here, a portion of the active layer 43 in the vicinity of a light-emitting surface 33 has a minimum thickness. A portion of the active layer 43 in the vicinity of a light-reflecting surface 34 has a maximum thickness. Specifically,

$T_{max}$ = 102 nm;

$T_{min}$ = 98 nm; and

$T_{ave}$ = 100 nm.

The composition of the active layer 43 varies in the longitudinal direction of the ridge portion 30. Furthermore, the following expression is satisfied:

$$\Delta\lambda/\lambda_{max} \ge 1.5 \times 10^{-4}$$

where $\lambda_{max}$ represents the peak maximum of wavelengths of light emitted from the semiconductor light-emitting element, and $\Delta\lambda$ represents the wavelength width of the light. Specifically,

$\lambda_{max}$ = 640 nm; and

$\Delta\lambda$ = 0.6nm.

An antireflective coating (AR) or a low-reflection coating is provided on the light-emitting surface 33. A high-reflection coating (HR) is provided on the light-reflecting surface 34. These coatings are not illustrated.

In the first embodiment, as the substrate 10, an n-GaAs substrate is used. Table 2 describes the structure of the compound semiconductor multilayer structure 31 composed of a GaInP-based compound semiconductor in the semiconductor light-emitting element configured to emit red light. The compound semiconductor layer described in the bottom is formed on the substrate 10. The active layer 43 composed of an AlGaInP-based compound semiconductor has a multi-quantum well structure in which well layers including GaInP layers or AlGaInP layers and barrier layers including AlGaInP layers are stacked. Specifically, four barrier layers and three well layers are used.

Table 2

| | |
|---|---|
| Second compound semiconductor layer 42 | |
| contact layer | p-GaAs |
| second cladding layer | p-AlInP |
| second guide layer | AlGaInP |
| Active layer 43 | |
| well layer/barrier layer | GaInP/AlGaInP |
| First compound semiconductor layer 41 | |
| first guide layer | AlGaInP |
| first cladding layer | n-AlInP |
| Buffer layer 10' | GaInP |

A method for producing the semiconductor light-emitting element according to the first embodiment will be described below with reference to Figs. 3A and 3B which are schematic partial cross-sectional views taken along line IIIC-IIIC in Fig. 1A.

Step-100

The recess 20 having a width that varies in the longitudinal direction of the ridge portion 30 to be formed is formed in the substrate 10. Specifically, the recess 20 is formed on a main surface of the substrate 10 composed of n-GaAs by a photolithography technique and an etching technique (specifically, a reactive ion etching (RIE) method) in the related art (see Figs. 2A and 2B).

Step-110

The compound semiconductor multilayer structure 31 including the active layer 43 is formed on the substrate 10. This provides the active layer 43 having a thickness that varies in the longitudinal direction of the ridge portion 30 to be formed and having a composition that varies in the longitudinal direction of the ridge portion 30 to be formed. Specifically, crystals of various compound semiconductor layers are grown by an MOCVD method. Here, for example, phosphine ($PH_3$) may be used as a phosphorus source. Trimethylgallium (TMG) gas or triethylgallium (TEG) gas may be used as a gallium source. Trimethylaluminum (TMA) gas may be used as an aluminum source. Trimethylindium (TMI) gas may be used as an indium source. Monosilane ($SiH_4$ gas) may be used as a silicon source. Cyclopentadienylmagnesium gas may be used as a magnesium source.

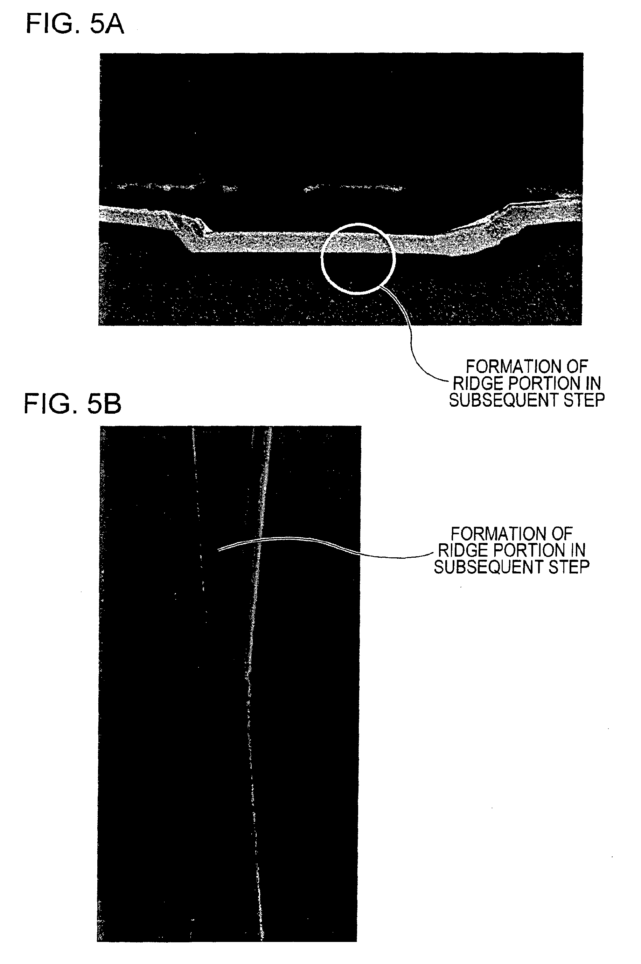

More specifically, the buffer layer 10', the first compound semiconductor layer 41, the active layer 43, and the second compound semiconductor layer 42 are epitaxially grown on the substrate 10 including the recess 20 by a usual MOCVD method, i.e., a MOCVD method using an organometallic compound and a hydrogen compound as source gases, thereby providing a structure illustrated in Fig. 3A which is a schematic partial cross-sectional view and Figs. 5A and 5B which are scanning electron micrographs. Fig. 5A is a scanning electron micrograph of the compound semiconductor multilayer structure 31 when viewed from the light-emitting surface. In this figure, the ridge portion 30 will be formed in a region surrounded by a circle in the subsequent step. Fig. 5B is a scanning electron micrograph of the compound semiconductor multilayer structure 31 when viewed from above. Fig. 5B illustrates a process for producing two semiconductor light-emitting elements. The structure will be cleaved along the horizontal center line in the micrograph in the subsequent step to form the light-emitting surface 33.

Usually, in the case of forming the compound semiconductor layer by the MOCVD method, large amounts of the source gases are fed to a wide portion of the recess 20, compared with a narrow portion of the recess 20. This results in the formation of the active layer 43 having a thickness that varies in the longitudinal direction of the ridge portion 30 to be formed. Furthermore, a large amount of In is incorporated into the wide portion of the recess 20, compared with the narrow portion of the recess 20. Thereby, the composition of the active layer 43 varies in the longitudinal direction of the ridge portion 30. Table 3 summarizes these results.

Table 3

|  | Width of recess | Thickness of active layer | In content | Oscillation wavelength |
|---|---|---|---|---|
| In vicinity of light-reflecting surface | wide | thick | high | long |
| In vicinity of light-emitting surface | narrow | thin | low | short |

Step-120

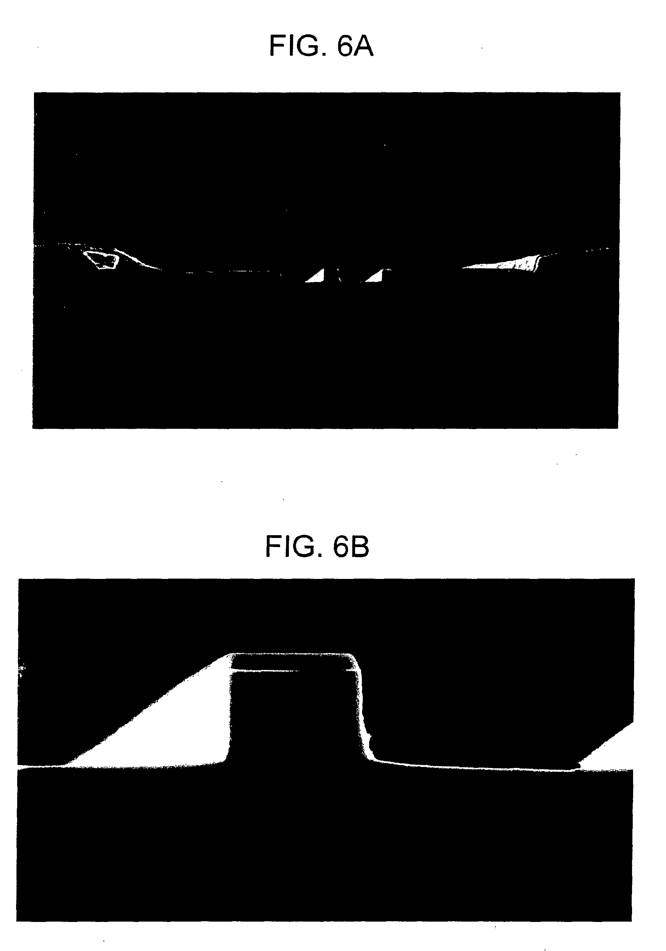

A portion of the compound semiconductor multilayer structure 31 in the recess 20 is etched by a photolithography technique and an etching technique in the related art to form the ridge portion 30 having a constant width. Specifically, predetermined portions of the second compound semiconductor layer 42 are removed in the thickness direction by etching. Thereby, the side structure 32 formed of the compound semiconductor multilayer structure 31 is formed simultaneously with the formation of the ridge portion 30, the side structure 32 being located on each side of the ridge portion 30 in the recess 20 with a distance kept between the side structure 32 and the ridge portion 30. This results in the formation of a structure illustrated in Fig. 3B which is a schematic partial cross-sectional view and Figs. 6A and 6B which are scanning electron micrographs. Fig. 6A is a scanning electron micrograph of the ridge portion 30, the side structures 32, and the compound semiconductor multilayer structure 31 when viewed from the light-emitting surface. Fig. 6B is an enlarged view of the scanning electron micrograph of Fig. 6A.

Step-130

An insulation layer 46 composed of $SiO_2$, SiN, and $Al_2O_3$ is formed (deposited) by a CVD method on the entire surface. A portion of the insulation layer 46 located on the top face of the second compound semiconductor layer 42 is removed by a photolithography technique and an etching technique. A second electrode 45 extending from the exposed top face of the second compound semiconductor layer 42 to a surface of the insulation layer 46 is formed by a lift-off process. A first electrode 44 is formed by a method in the related art on the backside of the substrate 10. Thereby, the semiconductor light-emitting element according to the first embodiment is completed (see Fig. 1C).

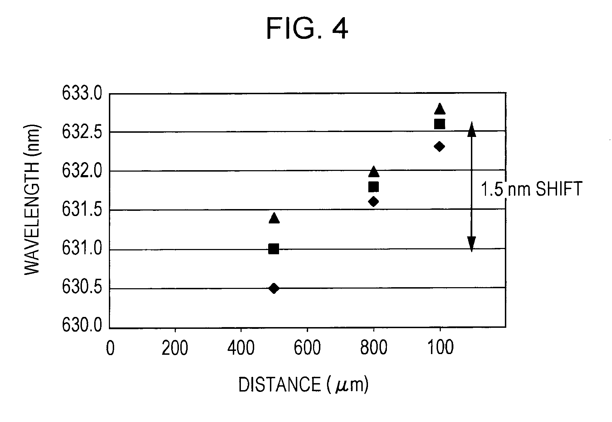

On the basis of the compound semiconductor multilayer structure 31 produced in Step-120, the gain peak wavelength of semiconductor emission was measured by a photoluminescence (PL) method. Fig. 4 illustrates the measurement results of the gain peak wavelength of semiconductor emission in a region of the compound semiconductor multilayer structure 0.50 mm away from the light-reflecting surface 34, a region of the compound semiconductor multilayer structure 0.80 mm away from the light-reflecting surface 34, and a region of the compound semiconductor multilayer structure 1.00 mm away from the light-reflecting surface 34 (a region in the vicinity of the light-emitting surface 33). The vertical axis in Fig. 4 represents the gain peak wavelength of semiconductor emission. The horizontal axis represents the distance from the light-reflecting surface 34 to the measurement region of the compound semiconductor multilayer structure. The results illustrated in Fig. 4 demonstrate that the gain peak wavelength of semiconductor emission shifts by 1.5 nm from 632.5 nm at the light-reflecting surface 34 to 631.0 nm at the light-emitting surface 33.

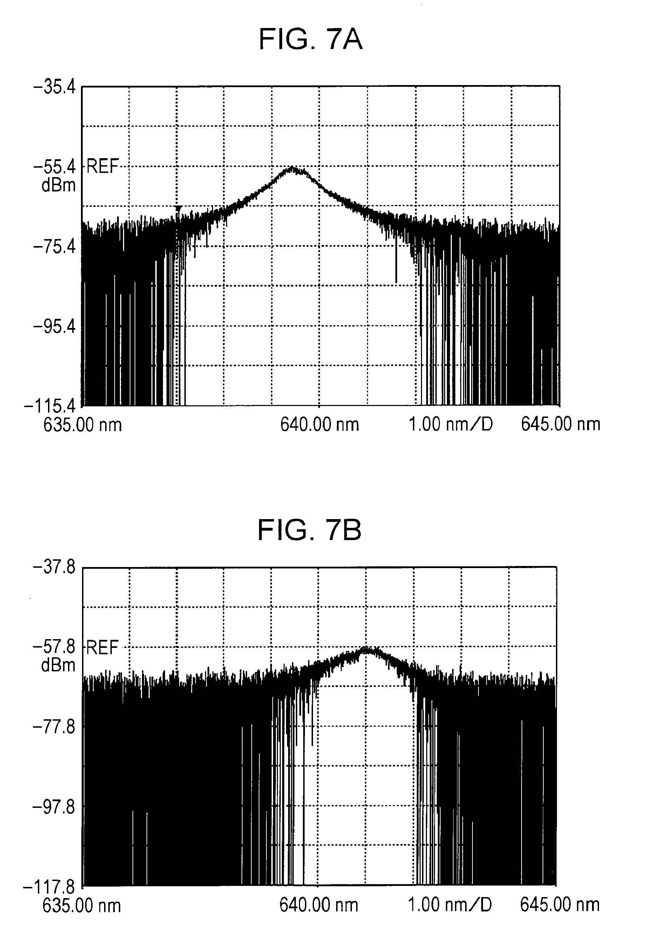

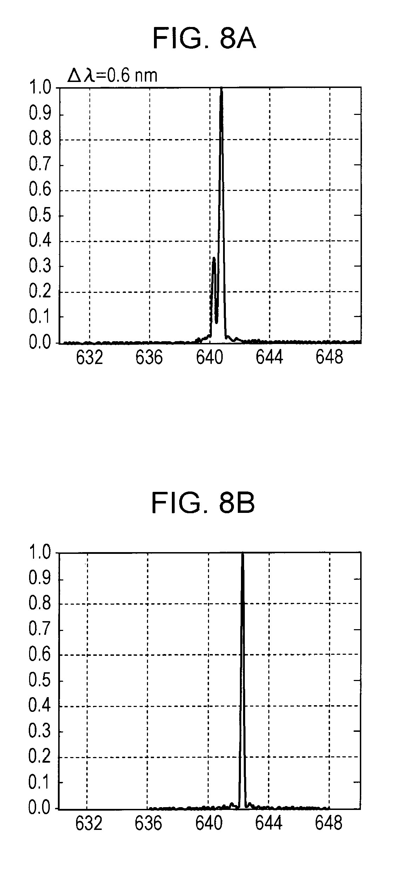

A semiconductor light-emitting element according to a first comparative embodiment was produced as a prototype by forming a compound semiconductor multilayer structure and so forth similar to that in the first embodiment on a main surface of the substrate 10 composed of n-GaAs without forming the recess 20. Figs. 7A and 7B illustrate emission spectra in the vicinity of $I_{th}$ of the semiconductor light-emitting elements according to the first embodiment and the first comparative embodiment. In the semiconductor light-emitting element according to the first embodiment, the width of the gain curve was about 5.0 nm. In contrast, in the semiconductor light-emitting element according to the first comparative embodiment, the width of the gain curve was about 3.5 nm. The results demonstrate that the semiconductor light-emitting element according to the first embodiment has a wider gain curve than the first comparative embodiment. Figs. 8A and 8B illustrate emission spectra of the semiconductor light-emitting elements according to the first embodiment and the first comparative embodiment. The semiconductor light-emitting element according to the first embodiment exhibits a plurality of oscillation peaks, specifically, two oscillation peaks. The semiconductor light-emitting element according to the first comparative embodiment exhibits a single oscillation peak. Each of the two light beams (laser light beams) emitted from the semiconductor light-emitting element according to the first embodiment was determined to be in the fundamental transverse mode.

As described above, in the semiconductor light-emitting element according to the first embodiment, the thickness of the active layer 43 varies in the longitudinal direction of the ridge portion 30. This results in an increase in the wavelength width $\Delta\lambda$ of light emitted from the semiconductor light-emitting element, thereby reducing speckle noise. Furthermore, the ridge portion 30 having a constant width is formed in the recess 20 provided in the substrate 10. Thus, the crystallinity of the compound semiconductor multilayer structure 31 including the active layer 43 is not reduced, thereby providing a highly reliable semiconductor light-emitting element. Incidentally, in the semiconductor laser element, in the case where the gain peak wavelength of semiconductor emission at the light-emitting surface 33 is shorter than the gain peak wavelength of semiconductor emission at the light-reflecting surface 34, the optical loss is reduced to improve reliability. Thus, the width of the recess 20 is preferably reduced in the vicinity of the light-emitting surface 33.

In the case where a predetermined current was passed through the active layer 43 via the first electrode 44 and the second electrode 45 and where a high-frequency signal (for example, 100 MHz to 300 MHz, more specifically, 170 MHz) was superimposed, gain fluctuation is induced, thus further increasing the value of $\Delta\lambda/\lambda_{max}$ and more effectively reducing the speckle noise. Specifically, when the high-frequency signal was superimposed, the value of $\Delta\lambda$ was increased from 0.6 nm to 1.6 nm, and the value of the $\Delta\lambda/\lambda_{max}$ was increased from $9.4 \times 10^{-4}$ to $2.5 \times 10^{-3}$.

Second embodiment

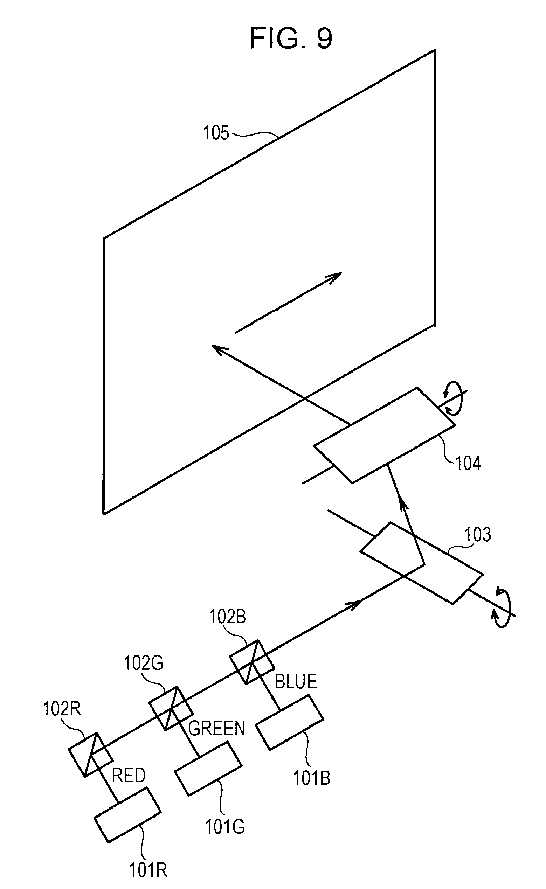

A display apparatus according to a second embodiment of the present disclosure will be described below. In the second embodiment, as the display apparatus, a raster scan type projection apparatus equipped with a semiconductor light-emitting element as a light source is used, as illustrated in Fig. 9 which is a conceptual diagram. The projection apparatus displays an image by raster-scanning laser light emitted from a semiconductor light-emitting element formed of a semiconductor laser element serving as a light source while controlling the brightness of the laser light in response to the image to be displayed. Specifically, laser beams emitted from a semiconductor light-emitting element 101R configured to emit red light, a semiconductor light-emitting element 101G configured to emit green light, and a semiconductor light-emitting element 101B configured to emit blue light are combined into a single laser beam with dichroic prisms 102R, 102G, and 102B. The resulting laser beam is scanned by a horizontal scanner 103 and a vertical scanner 104 and projected on a laser irradiation plane 105, such as a screen or wall surface, to display an image or video image, thereby forming an image. The horizontal scanner 103 and the vertical scanner 104 may be formed of a combination of, for example, a polygon mirror and a galvano-scanner. Other examples of the horizontal scanner 103 and the vertical scanner 104 include a combination of a plurality of digital micro-mirror devices (DMDs) produced by micro-electrical-mechanical system (MEMS) technology, a polygon mirror, and a galvano-scanner; the integrated structure of a horizontal scanner and a vertical scanner, i.e., a two-dimensional spatial modulator in which DMDs are two-dimensionally arrayed in a matrix; and a two-dimensional MEMS scanner in which a two-dimensional scan is performed by a single DMD. Furthermore, a refractive index modulation type scanner, e.g., an acousto-optic effect scanner or an electro-optic effect scanner, may also be used.

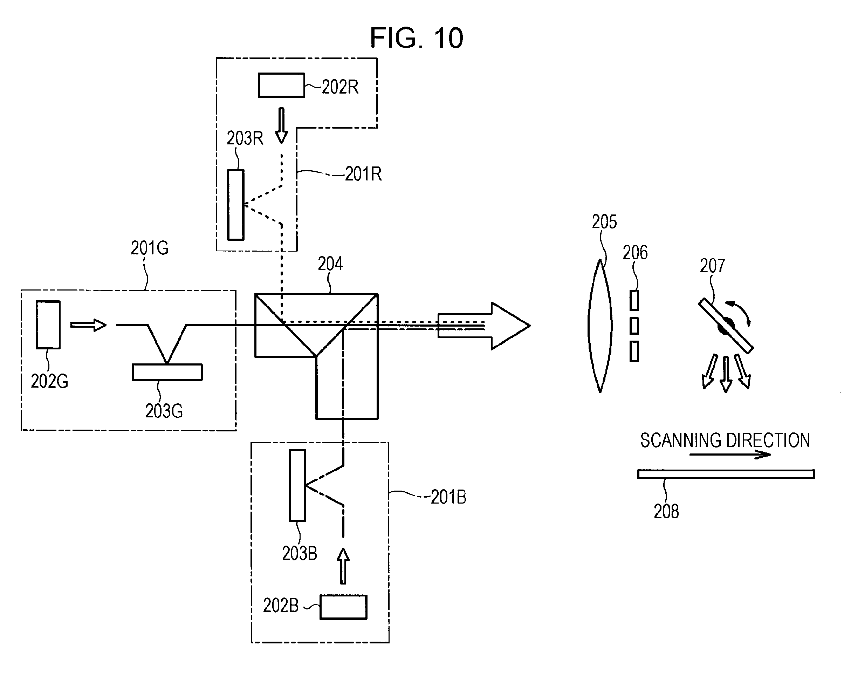

A further example of the horizontal scanner 103 and the vertical scanner 104 is a combination of a plurality of grating light valve (GLV) elements, which serve as a one-dimensional spatial modulator, a polygon mirror, and a galvano-scanner. As illustrated in Fig. 10 which is a conceptual view, the display apparatus includes an image formation device 201R including a GLV element 203R and a laser light source (semiconductor laser configured to emit red light) 202R, an image formation device 201G including a GLV element 203G and a laser light source (semiconductor laser configured to emit green light) 202G, and an image formation device 201B including a GLV element 203B and a laser light source (semiconductor laser configured to emit blue light) 202B. Here, red laser light emitted from the laser light source (semiconductor laser configured to emit red light) 202R is indicated by a dotted line. Green laser light emitted from the laser light source (semiconductor laser configured to emit green light) 202G is indicated by a solid line. Blue laser light emitted from the laser light source (semiconductor laser configured to emit blue light) 202B is indicated by an alternate long and short dashed line. The display apparatus further include collective lenses configured to collect laser beams emitted from the laser light sources 202R, 202G, and 202B and to allow the laser beams to enter the GLV elements 203R, 203G, and 203B (not illustrated); an L-shaped prism 204 configured to combine the laser beams emitted from the GLV elements 203R, 203G, and 203B into a single beam; a lens 205 and a spatial filter 206 through which the combined laser beam of the three primary colors pass; an image-forming lens (not illustrated) configured to focus the combined laser beam that has passed through the spatial filter 206 and to form an image; a scan mirror (galvano-scanner) 207 configured to scan the combined laser beam passing through the image-forming lens; and a screen (laser irradiation plane) 208 on which the laser beam scanned by the scan mirror 207 is projected.

While the present disclosure has been described on the basis of the preferred embodiments, the present disclosure is not limited to these embodiments. The configurations and the structures of the semiconductor light-emitting element and the display apparatus described in the embodiments and the method for producing a semiconductor light-emitting element are illustrative and may be changed as appropriate. The values of the peak maximum $\lambda_{max}$ of wavelengths of light emitted from the semiconductor light-emitting element, the wavelength width $\Delta\lambda$ of the light, and so forth may be determined on the basis of specifications for the semiconductor light-emitting element. The values of the maximum width $W_{max}$ of the recess, the minimum width $W_{min}$ of the recess, the average width Wave of the recess, the maximum thickness $T_{max}$ of the active layer, the minimum thickness $T_{min}$ of the active layer, the average thickness $T_{ave}$ of the active layer, and so forth may be appropriately determined by conducting various tests on the basis of specifications for the semiconductor light-emitting element. Even when the active layer composed of a GaInN-based compound semiconductor was used in place of the active layer composed of the GaInP-based compound semiconductor, the same results were obtained.

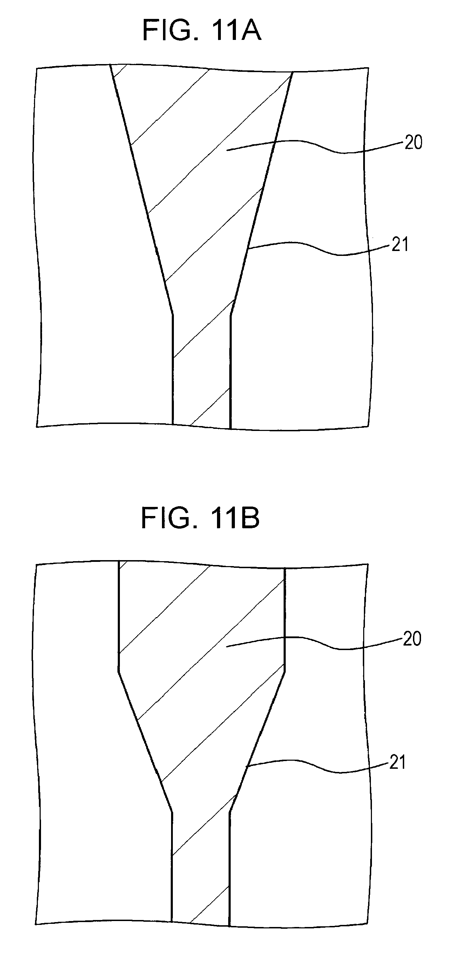

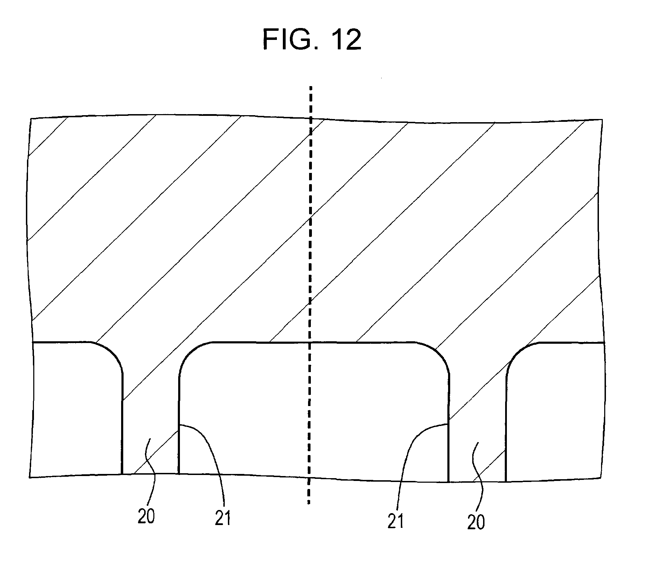

In the embodiments, while the shape of the edge portions of the recess is linear, the shape is not limited thereto. Examples of the shape of the recess include divergent shapes defined by combinations of straight lines. Specific examples the shape of the recess include a shape defined by a combination of a narrow region having a constant width and a divergent region having a linearly increasing width (see Fig. 11A which is a schematic partial plan view of a recess in a substrate according to a modified embodiment); and a shape defined by a combination of a narrow region having a constant width, a divergent region having a linearly increasing width, and a wide region having a constant width (see Fig. 11B which is a schematic partial plan view of a recess in a substrate according to a modified embodiment). Furthermore, as illustrated in Fig. 12 which is a schematic partial plan view of a recess in a substrate according to a modified embodiment, an example of the shape of the recess is a shape defined by a combination of a narrow region having a constant width and a region having a large width (provided that this region is connected to an adjacent region having a large width in the substrate in which a semiconductor light-emitting element will be formed. In the modified embodiment illustrated in Fig. 12, the value of $W_{max}$ is infinite, so the value of $[(W_{max}-W_{min})/W_{ave}]$ has no meaning. In Fig. 12, the broken line indicates the boundary between adjacent semiconductor light-emitting elements. Further exampled of the shape of the recess include a divergent shape defined by curved lines; and a divergent shape defined by a combination of straight lines and curved lines.

In the embodiments, the semiconductor light-emitting element is the semiconductor laser element. However, a superluminescent diode (SLD) may be formed from the compound semiconductor multilayer structure 31 described in the first embodiment (see Table 2). The SLD has the same optical waveguide structure as the semiconductor laser element described in the first embodiment. Unlike the semiconductor laser element, the SLD does not have a resonator structure. In the SLD, spontaneously emitted light due to current injection is amplified by stimulated emission during passing through the optical waveguide structure and then emitted. Such an SLD may be obtained by setting the reflectivity of the light-emitting surface to a very low value and setting the reflectivity of the light-reflecting surface to a very high value.

Embodiments of the present disclosure may also include the following configurations.

Semiconductor light-emitting element

1. A semiconductor light-emitting element includes:

a ridge portion disposed in a recess in a substrate, the ridge portion having a constant width,
in which the recess has a width that varies in the longitudinal direction of the ridge portion,
the ridge portion is formed of a compound semiconductor multilayer structure including an active layer, and
the active layer has a thickness that varies in the longitudinal direction of the ridge portion.

2. In the semiconductor light-emitting element described in item 1, the active layer has a composition that varies in the longitudinal direction of the ridge portion.
3. In the semiconductor light-emitting element described in item 1 or 2, a side structure formed of the compound semiconductor multilayer structure is disposed on each side of the ridge portion in the recess with a distance kept between the side structure and the ridge portion.
4. In the semiconductor light-emitting element described in any one of items 1 to 3, the recess has a depth of 0.5 $\mu$m or more and 10 $\mu$m or less.
5. In the semiconductor light-emitting element described in any one of items 1 to 4, the following expression is satisfied,

$$0.8 \leq (W_{max} - W_{min})/W_{ave} \leq 2$$

where $W_{max}$ represents the maximum width of the recess, $W_{min}$ represents the minimum width of the recess, and $W_{ave}$ represents the average width of the recess.
6. In the semiconductor light-emitting element described in any one of items 1 to 5, the following expression is satisfied,

$$\Delta\lambda/\lambda_{max} \geq 1.5 \times 10^{-4}$$

where $\lambda_{max}$ represents the peak maximum of wavelengths of light emitted, and $\Delta\lambda$ represents the wavelength width of the light.
7. In the semiconductor light-emitting element described in any one of items 1 to 6, the following expression is satisfied,

$$0.01 \leq (T_{max} - T_{min})/T_{ave} \leq 0.1$$

where $T_{max}$ represents the maximum thickness of the active layer, $T_{min}$ represents the minimum thickness of the active layer, and $T_{ave}$ represents the average thickness of the active layer.
8. In the semiconductor light-emitting element described in item 7, a portion of the active layer in the vicinity of a light-emitting surface has a minimum thickness.
9. In the semiconductor light-emitting element described in any one of items 1 to 8, the active layer is composed of an AlGaInP-based compound semiconductor.
10. In the semiconductor light-emitting element described in item 9, the active layer has a quantum well structure in which a well layer including a GaInP layer or an AlGaInP layer and a barrier layer including an AlGaInP layer are stacked.
11. In the semiconductor light-emitting element described in item 10, a portion of the active layer in the vicinity of a light-emitting surface has a minimum In content.
12. In the semiconductor light-emitting element described in any one of items 1 to 8, the active layer is composed of a GaInN-based compound semiconductor.
13. In the semiconductor light-emitting element described in item 12, the active layer has a quantum well structure in which a well layer including a GaInN layer and a barrier layer including a GaInN layer having an In content different from the In content of the well layer are stacked.
14. In the semiconductor light-emitting element described in item 13, a portion of the active layer in the vicinity of a light-emitting surface has a minimum In content.
15. In the semiconductor light-emitting element described in any one of items 1 to 14, the semiconductor light-emitting element is formed of a semiconductor laser element or a superluminescent diode.

Method for producing semiconductor light-emitting element

16. A method for producing a semiconductor light-emitting element includes:

forming a recess in a substrate, the recess having a width that varies in the longitudinal direction of a ridge portion to be formed; and
forming a compound semiconductor multilayer structure including an active layer on the substrate, the active layer having a thickness that varies in the longitudinal direction of the ridge portion to be formed, and then forming the ridge portion by etching a portion of the compound semiconductor multilayer structure in the recess, the ridge portion having a constant width.

17. In the method for producing a semiconductor light-emitting element described in item 16, the active layer has a thickness and a composition that vary in the longitudinal direction of the ridge portion to be formed.
18. In the method for producing a semiconductor light-emitting element described in item 16 or 17, a side structure formed of the compound semiconductor multilayer structure is formed simultaneously with the ridge portion, the side structure being located on each side of the ridge portion in the recess with a distance kept between the side structure and the ridge portion.

Display apparatus

19. A display apparatus includes the semiconductor light-emitting element described in any one of items 1 to 15.

It should be understood by those skilled in the art that various modifications, combinations, sub-combinations and alterations may occur depending on design requirements and other factors insofar as they are within the scope of the appended claims or the equivalents thereof.

**Claims**

1. A semiconductor light-emitting element comprising:

a substrate;
a recess in the substrate; and
a ridge portion disposed in the recess, the ridge portion having a constant width,
wherein the recess has a width that varies in the longitudinal direction of the ridge portion,
the ridge portion is formed of a compound semiconductor multilayer structure including an active layer, and
the active layer has a thickness that varies in the longitudinal direction of the ridge portion.

2. The semiconductor light-emitting element according to claim 1, wherein the active layer has a composition that varies in the longitudinal direction of the ridge portion.

3. The semiconductor light-emitting element according to any of the preceding claims, wherein a side structure formed of the compound semiconductor multilayer structure is disposed on each side of the ridge portion in the recess with a distance kept between the side structure and the ridge portion.

4. The semiconductor light-emitting element according to any of the preceding claims, wherein the recess has a depth of 0.5 $\mu$m or more and 10 $\mu$m or less.

5. The semiconductor light-emitting element according to any of the preceding claims, wherein the following expression is satisfied,

$$0.8 \leq (W_{max} - W_{min})/W_{ave} \leq 2$$

where $W_{max}$ represents the maximum width of the recess, $W_{min}$ represents the minimum width of the recess, and Wave represents the average width of the recess.

6. The semiconductor light-emitting element according to any of the preceding claims, wherein the following expression is satisfied,

$$0.01 \leq (T_{max} - T_{min})/T_{ave} \leq 0.1$$

where $T_{max}$ represents the maximum thickness of the active layer, $T_{min}$ represents the minimum thickness of the active layer, and $T_{ave}$ represents the average thickness of the active layer.

7. The semiconductor light-emitting element according to claim 6, wherein a portion of the active layer in the vicinity of a light-emitting surface has a minimum thickness.

8. The semiconductor light-emitting element according to any of the preceding claims, wherein the active layer is composed of an AlGaInP-based compound semiconductor.

9. The semiconductor light-emitting element according to claim 8, wherein the active layer has a quantum well structure in which a well layer including a GaInP layer or an AlGaInP layer and a barrier layer including an AlGaInP layer are stacked.

10. The semiconductor light-emitting element according to claim 9, wherein a portion of the active layer in the vicinity of a light-emitting surface has a minimum In content.

11. The semiconductor light-emitting element according to any of the preceding claims, wherein the semiconductor light-emitting element is formed of a semiconductor laser element or a superluminescent diode.

12. A method for producing a semiconductor light-emitting element, comprising:

forming a recess in a substrate, the recess having a width that varies in the longitudinal direction of a ridge portion to be formed;
forming a compound semiconductor multilayer structure including an active layer on the substrate, the active layer having a thickness that varies in the longitudinal direction of the ridge portion to be formed; and then
forming the ridge portion by etching a portion of the compound semiconductor multilayer structure in the recess, the ridge portion having a constant width.

13. The method according to claim 12, wherein the active layer has a thickness and a composition that vary in the longitudinal direction of the ridge portion to be formed.

14. The method according to claim 12, wherein a side structure formed of the compound semiconductor multilayer structure is formed simultaneously with the ridge portion, the side structure being located on each side of the ridge portion in the recess with a distance kept between the side structure and the ridge portion.

15. A display apparatus comprising:

the semiconductor light-emitting element according to any of claims 1 to 11.

FIG. 1A

FIG. 1B

FIG. 1C

# FIG. 2A

$W_{max}$

IIB     IIB

20

21

$W_{min}$

# FIG. 2B

21   20

10

FIG. 3A

FIG. 3B

FIG. 3C

# FIG. 4

FIG. 5A

FORMATION OF
RIDGE PORTION IN
SUBSEQUENT STEP

FIG. 5B

FORMATION OF
RIDGE PORTION IN
SUBSEQUENT STEP

## FIG. 6A

## FIG. 6B

## FIG. 7A

## FIG. 7B

# FIG. 8A

# FIG. 8B

# FIG. 9

# FIG. 10

EP 2 770 591 A2

EP 2 770 591 A2

# FIG. 11A

20

21

# FIG. 11B

20

21

24

FIG. 12

20    21         21    20

**EP 2 770 591 A2**

**REFERENCES CITED IN THE DESCRIPTION**

**Patent documents cited in the description**

- JP 2013034820 A
- JP 2009025462 A
- JP 6275904 A